# EUROPÄISCHE PATENTSCHRIFT

(11) **EP 0 452 643 B1**
(45) Veröffentlichungstag und Bekanntmachung des Hinweises auf die Patenterteilung: **01.02.1995**
(21) Anmeldenummer: 91102977.5
(22) Anmeldetag: 27.02.1991
(51) Int. Cl.: H03H 1/00

(54) **Durchführungsfilter bzw. - kondensator**
Feedthrough filter resp. capacitor
Filtre resp. condensateur de traversée

(30) Priorität: 27.03.1990 DE 4009809
(43) Veröffentlichungstag der Anmeldung: 23.10.1991
(73) Patentinhaber: SIEMENS AKTIENGESELLSCHAFT, 80333 München (DE)
(72) Erfinder: Feth, Josef, W-7920 Heidenheim (DE); Kraus, Josef, W-8400 Regensburg (DE)

(56) Entgegenhaltungen:
- DE-A- 3 605 157
- DE-C- 864 286
- DE-C- 873 110
- GB-A- 1 261 019
- US-A- 3 289 118

## Beschreibung

Die Erfindung betrifft ein Durchführungsfilter bzw. -kondensator nach den Oberbegriffen von Anspruch 1 bzw. Anspruch 2.

Durchführungsfilter dieser Art befinden sich bereits auf dem Markt. Die Durchführungsfilter sind als reflektierende Tiefpaßfilter aufgebaut und für eine breitbandige Entstörung von Starkstrombetriebsmitteln, beispielsweise in geschirmten Räumen befindliche Motoren, aber auch von Anlagen und Geräten der Nachrichtentechnik, beispielsweise Fernmeldeanlagen, vorgesehen.

Die in π-Schaltung aufgebauten Durchführungsfilter bestehen im wesentlichen aus Zwei gleichen kapazitiven Quergliedern und einem ferromagnetischen induktiven Längsglied. Das Längsglied besteht aus einem Schraubbolzen, durch den der Betriebsstrom fließt, und aus einem Ferrit-Hohlzylinder, der über den Schraubbolzen geschoben ist. Infolge der konzentrischen Anordnung der Bauteile werden hohe Dämpfungswerte (ca. 80 dB bei 300 MHz) bis über 1 GHz erreicht. Um die Entstörwirkung auch bei höchsten Frequenzen voll auszunutzen, werden die Durchführungsfilter HF-dicht in eine Abschirmungswand eingesetzt, die den unentstörten Raum vom entstörten trennt.

Die Fertigung großer Stückzahlen von Durchführungsfiltern wird derzeit unter Verwendung der Kolbenlötung realisiert, bei der die elektrisch leitenden Verbindungen zwischen den Bauteilen des Filters durch Lötung von Hand mit Lötkolben erzeugt werden. Die Lötmethode und die Anzahl der Lötungen ergeben sich dabei zwangsläufig aus dem konstruktiven Aufbau des bekannten Durchführungsfilters. Bei diesem sind die zueinander parallel geschalteten Kapazitäten als koaxiale Durchführungskondensatoren ausgebildet, deren eine Belegungen jeweils am Durchführungsleiter und deren andere am Filtergehäuse liegen, wobei die Durchführungskondensatoren selbst wiederum koaxial zueinander angeordnet sind.

Das bekannte Durchführungsfilter weist außerdem eine relativ geringe stufenförmige Versetzung des inneren Durchführungskondensators zum koaxial darüber angeordneten äußeren Durchführungskondensators auf. Aus geometrischen Gründen ist es deshalb erforderlich, daß die für die Kontaktierung des Filtergehäuses vorgesehene Belegung des inneren Durchführungskondensators mit einer leitenden Fiederfolie verlötet wird, die dann zwischen den beiden Wickelkondensatoren hindurch bis zur stufenförmigen Versetzung geführt und dort mit der für die Kontaktierung des Filtergehäuses vorgesehene Belegung des äußeren Wickelkondensators und einem zum Filtergehäuse führenden Leiter verlötet wird. Dieser herkömmliche konstruktive Aufbau ist in mehrfacher Hinsicht noch nicht zufriedenstellend:
- Die für den Kontakt mit dem Filtergehäuse vorgesehenen Belegungen der beiden Wickelkondensatoren müssen bei der Fertigung aus konstruktiven Gründen nacheinander in zwei verschiedenen Lötvorgängen mit der Fiederfolie kontaktiert werden.
- Aufgrund der koaxialen Anordnung der beiden Wickelkondensatoren zueinander ergeben sich unterschiedliche geometrische Abmessungen der beiden Wickelkondensatoren. Ferner sind unterschiedlich große Lötscheiben für die Verbindung der Belegungen der beiden Wickelkondensatoren mit dem Durchführungsleiter erforderlich.

Die notwendige Verwendung unterschiedlicher Teile ist aufwendig.
- Die bisherige konstruktive Gestaltung ist nur unter Einsatz einer Kolbenlötung von Hand realisierbar; da unter den gegebenen konstruktiven Voraussetzungen kein automatisierbares Lötverfahren, beispielsweise HF-Lötung, einsetzbar ist, ist die Herstellung der bekannten Durchführungsfilter also auch von daher relativ unrationell.

Ein weiterer bekannter, mit räumlich in Reihe liegenden Kondensatoren ist aus DE-C 873 110 bekannt.

Der vorliegenden Erfindung liegt die Aufgabe zugrunde, Entstör-Durchführungselemente, insbesondere ein Durchführungsfilter bzw. einen -kondensator der eingangs genannten Art zu schaffen, die durch eine vereinfachte Konstruktion, durch Mehrfachverwendung von Teilen und Einführung von weitgehend automatisierbaren Lötverfahren besonders rationell herstellbar sind und nicht zuletzt wenig kostenaufwendig sind.

Zur Lösung dieser Aufgabe sieht die Erfindung bei einem Durchführungsfilter der eingangs genannten Art vor, daß jeweils koaxial zum Durchführungsleiter und nebeneinanderliegend Ferrit-Rohrkerne aufgebracht sind, daß jeder Ferrit-Rohrkern von einem Wickelkondensator koaxial umschlossen ist, daß auf die zueinander gekehrten, beschoopten Stirnflächen der Wickelkondensatoren ringförmige Lötscheiben aufgelötet sind, und daß die Lötscheiben zumindest in ihren Randbereichen miteinander und mit dem Filtergehäuse mittels automatisiertem Löten miteinander verbunden sind.

Soweit es sich um einen Durchführungskondensator gemäß Oberbegriff des Patentanspruchs 2 handelt, wird die Aufgabe auch dadurch gelöst, daß jeweils koaxial zum Durchführungsleiter und nebeneinanderliegend Wickelkondensatoren angeordnet sind, daß auf die zueinander gekehrten, beschoopten Stirnflächen der Wikkelkondensatoren ringförmige Lötscheiben aufgelötet sind, und daß die Lötscheiben zumindest in ihren Randbereichen miteinander und mit dem Filtergehäuse mittels automatisiertem Löten miteinander verbunden sind.

Weitere vorteilhafte Ausgestaltungen und Weiterbildungen der Erfindung sind Gegenstand zusätzlicher Ansprüche.

Die Erfindung wird nachstehend anhand eines Ausführungsbeispieles und eines Vergleichs mit bisher üblichen Durchführungsfiltern näher erläutert. Es zeigt:
- FIG 1: eine teilweise geschnittene und gebrochene Darstellung der wesentlichen Elemente eines bekannten Durchführungsfilters,
- FIG 2: ein Durchführungsfilter nach der Erfindung in der Darstellung nach FIG 1.

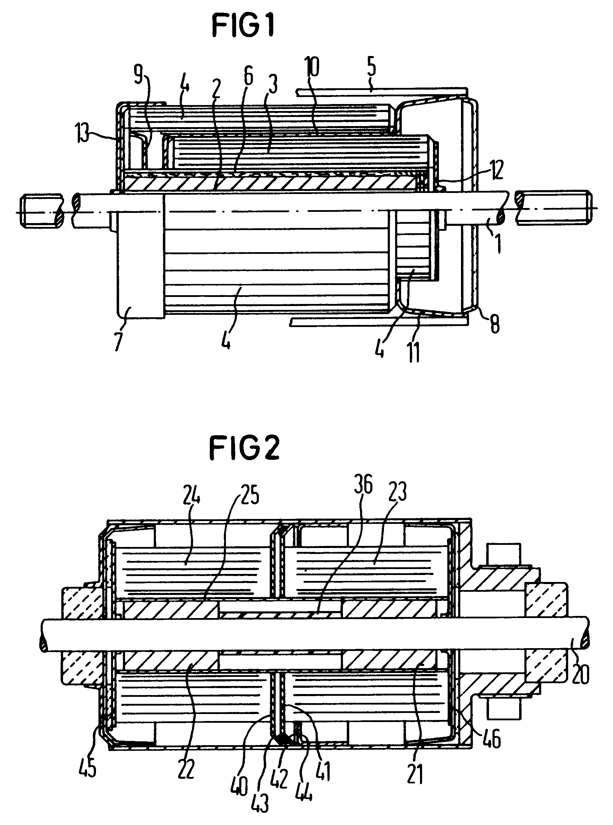

FIG 1 zeigt einen als Schraubbolzen 1 ausgebildeten Durchführungsleiter, der konzentrisch von einem Ferrit-Rohrkern 2, einem Wickelkondensator 3 eines inneren koaxialen Durchführungskondensators, einem Wickelkondensator 4 eines äußeren koaxialen Durchführungskondensators 4 und einem rohrförmigen Filtergehäuse 5 umgeben ist. Die beiden Wickelkondensator 3 und 4 sind durch ein Isolierpapier 6 getrennt. Das Innere des Filtergehäuses 5 ist auf der einen Stirnseite durch eine Isolierkappe 7 und teils durch eine Isolierkappe 9 und auf der anderen Stirnseite durch einen Deckel 8 aus Isolierstoff geschlossen.

Aus FIG 1 geht hervor, daß der innere und äußere Wickelkondensator 3 bzw. 4 zwar konzentrisch aber geringfügig versetzt zueinander angeordnet sind. Bei der Fertigung wird an die zur Kontaktierung mit dem Filtergehäuse 5 vorgesehene Belegung des inneren Wickelkondensators 3 zunächst eine elektrisch leitende Fiederfolie 10 angelötet und anschließend der innere Wickelkondensator 3 in den äußeren Wickelkondensator 4 eingesetzt, so daß die Fiederfolie zwischen beiden Wickelkondensatoren 3 und 4 zu der dem Filtergehäuse 5 zugeordneten Belegung des äußeren Wickelkondensators 4 geführt und mit dieser in einem zweiten Lötvorgang verlötet wird. Dabei wird gleichzeitig ein Kontaktkorb 11 an diese Belegung gelötet, der in einem weiteren Arbeitsgang mit der Innenseite des Filtergehäuses 5 verlötet wird. Vor dem Einbringen der genannten Bauteile in das Filtergehäuse 5 werden an je eine Belegung des inneren Wickelkondensators 3 und des äußeren Wickelkondensators 4 unterschiedlich große Lötscheiben 12 und 13 angelötet, die wiederum mit dem Durchführungsleiter 1 verlötet werden.

In FIG 1 ist auch erkennbar, daß die Stirnfläche bzw. Belegung des äußeren Wickelkondensators 4, an die der Kontaktkorb 11 angelötet wird, zu klein ist, um einer Lötscheibe sicheren Kontakt bieten zu können. Dies und die Schwierigkeit, den inneren Wickelkondensator 3 vor dem Einsetzen so zu präparieren, daß er später von außen automatisiert gelötet werden kann, machen das bekannte Durchführungsfilter und analog konstruierte Durchführungskondensatoren für ein rationelles automatisiertes Lötverfahren ungeeignet.

FIG 2 zeigt ein Durchführungsfilter nach der Erfindung mit einem als Schraubbolzen ausgebildeten Durchführungsleiter 20, auf dem koaxial und nebeneinanderliegend Ferrit-Rohrkerne 21 und 22 aufgebracht sind. Diese können auch durch einen einzelnen Ferrit-Rohrkern mit entsprechenden Eigenschaften ersetzt werden. Zwischen den Ferrit-Rohrkernen 21 und 22 können Abstandshalter 36, beispielsweise Preßspan oder Isolierschläuche, zur Trennung angeordnet sein. Die Ferrit-Rohrkerne 21 und 22 sind jeweils von als Durchführungskondensatoren ausgebildeten Wickelkondensatoren 23 und 24 koaxial umschlossen und die nebeneinander angeordneten Wickelkondensatoren 23 und 24 sind insgesamt von einem rohrförmigen Filtergehäuse 25 umgeben.

Wie weiterhin aus FIG 2 hervorgeht, sind auf die zueinander gekehrten, beschoopten Stirnflächen der Wickelkondensatoren 23 und 24 ringförmige Lötscheiben 40 und 41 aufgelötet, die in ihren Randbereichen miteinander und mit dem Filtergehäuse 25 durch eine Lötung verbunden sind. Durch diese konstruktive Gestaltung können vorteilhafterweise beide Wickelkondensatoren 23 und 24 gleichzeitig, also durch einen Lötvorgang mittels automatisiertem Löten an das Filtergehäuse 25 angelötet und miteinander verbunden werden. Vorteilhafterweise sind die Lötscheiben 40 und 41 so gestaltet, daß sie mit ihren äußeren Stirnrändern gegen die Wandung des Filtergehäuses 25 anliegen. Als Verfahren zum automatisiertem Löten bietet sich das bekannte HF-Löten an, bei dem das Filtergehäuse ungefähr in der Ebene der Lötscheiben 40 und 41 von einer Induktionsschleife umgeben wird, durch die eine Erhitzung der Lötstellen 42, 43 und 44 erfolgt, die im wesentlichen auf diesen Bereich beschränkt bleibt. Es ist natürlich auch möglich, eine andere Wärmequelle zum Löten einzusetzen, indem amn beispielsweise das Filtergehäuse 25 mit einem Ringbrenner umgibt. Für die in FIG 2 nur über Lage nach angedeuteten Lötstellen 43 und 44 kann beispiels weise ein Röhrenlot verwendet werden. Ein besonders günstiger Lötzinnfluß ergibt sich, wenn, wie in FIG 2 dargestellt, die Lötscheiben 40 und 41 in den Bereichen ihrer äußeren Stirnränder gegen die Wandung des Filtergehäuses 25 geneigt sind. Durch die erfindungsgemäße Gestaltung des Durchführungsfilters läßt sich die Fertigung durch Verwendung einer automatisierten Lötung, durch die geringere Anzahl von notwendigen Lötungen und durch den Wegfall der Fiederfolie erheblich rationalisieren.

An die übrigen Belegungen der Wickelkondensatoren 23 und 24 werden gleich große Lötscheiben 45 und 46 angelötet, die wiederum mittels automatisiertem Löten mit dem Durchführungsleiter 20 verbunden werden. Durch die erfindungsgemäße Ausgestaltung mit nebeneinanderliegenden Wickelkondensatoren 23 und 24 gelingt es, das Durchführungsfilter mit Hilfe zweier in ihren Abmessungen einheitlicher Wickelkondensatoren aufzubauen, bei denen deshalb auch gleich große Lötscheiben verwendet werden können. Insgesamt ist das Durchführungsfilter nach der Erfindung konstruktiv erheblich vereinfacht, ohne daß dies zu Lasten der guten HF-Schirmeigenschaften des Filters ginge.

Es ist natürlich auch möglich, die in den letzten beiden Absätzen geschilderten Maßnahmen bei einem Durchführungskondensator nach der Erfindung zu verwirklichen und dabei die geschilderten Vorteile in gleicher Weise zu erzielen.

## Patentansprüche

1. Durchführungsfilter mit koaxial durch ein Filtergehäuse geführtem, als Schraubbolzen ausgebildeten Durchführungsleiter mit im Gehäuseinneren in Reihe liegender Induktivität und mit zueinander parallel geschalteten Kapazitäten, deren eine Belegungen am Durchführungsleiter und deren andere am Filtergehäuse liegen,
**dadurch gekennzeichnet**,
daß jeweils koaxial zum Durchführungsleiter (20) und nebeneinanderliegend Ferrit-Rohrkerne (21, 22) aufgebracht sind, daß jeder Ferrit-Rohrkern (21, 22) von einem Wickelkondensator (23, 24) koaxial umschlossen ist, daß auf die zueinander gekehrten, beschoopten Stirnflächen der Wickelkondensatoren (23, 24) ringförmige Lötscheiben (40, 41) aufgelötet sind, und daß die Lötscheiben (40, 41) zumindest in ihren Randbereichen miteinander und mit dem Filtergehäuse (25) mittels automatisiertem Löten miteinander verbunden sind.

2. Durchführungskondensator mit koaxial durch ein becherförmiges Kondensatorgehäuse geführtem, als Schraubbolzen ausgebildeten Durchführungsleiter mit im Kondensatorgehäuseinneren angeordneten, zueinander parallel geschalteten Kapazitäten, deren eine Belegungen am Durchführungsleiter und deren andere am Kondensatorgehäuse liegen,
**dadurch gekennzeichnet**,
daß jeweils koaxial zum Durchführungsleiter und nebeneinanderliegend Wickelkondensatoren angeordnet sind, daß auf die zueinander gekehrten, beschoopten Stirnflächen der Wickelkondensatoren ringförmige Lötscheiben aufgelötet sind, und daß die Lötscheiben zumindest in ihren Randbereichen miteinander und mit dem Filtergehäuse mittels automatisiertem Löten miteinander verbunden sind.

3. Durchführungsfilter bzw. -kondensator nach Anspruch 1 oder 2,
**dadurch gekennzeichnet**,
daß die Lötscheiben (40, 41) mit ihren äußeren Stirnrändern gegen die Gehäuseinnenwandung anliegen.

4. Durchführungsfilter bzw. -kondensator nach Anspruch 3,
**dadurch gekennzeichnet**,
daß die Lötscheiben (40, 41) in den Bereichen ihrer äußeren Stirnränder gegen die Gehäuseinnenwandung geneigt sind.

5. Durchführungsfilter nach Anspruch 1,
**dadurch gekennzeichnet**,
daß die Ferrit-Rohrkerne (21, 22) durch Abstandshalter (36) voneinander getrennt sind.

6. Durchführungsfilter nach Anspruch 1,
**dadurch gekennzeichnet**,
daß die Ferrit-Rohrkerne (21, 22) durch einen einzelnen Ferrit-Rohrkern ersetzt sind.

## Claims

1. Bushing filter having a bushing conductor, bushed coaxially through a filter housing and constructed as a threaded bolt, having an inductance connected in series in the inside of the housing, and having capacitances connected in parallel to each other whose one plates are connected to the bushing conductor and whose other plates are connected to the filter housing, characterized in that tubular ferrite cores (21, 22) are applied in each case coaxially to the bushing conductor (20) and lying side by side, in that each tubular ferrite core (21, 22) is coaxially surrounded by a wound capacitor (23, 24), in that annular soldering discs (40, 41) are soldered to the mutually facing, metal-plated end faces of the wound capacitors (23, 24), and in that the soldering discs (40, 41) are connected at least in their edge regions to one another and to the filter housing (25) by means of automatic soldering.

2. Bushing capacitor having a bushing conductor, bushed coaxially through a cup-shaped capacitor housing and constructed as threaded bolt, and having capacitances, arranged in the inside of the capacitor housing and connected in parallel to one another, whose one plates are connected to the bushing conductor and whose other plates are connected to the capacitor housing, characterized in that wound capacitors are arranged in each case coaxially to the bushing conductor and lying side by side, in that annular soldering discs are soldered to the mutually facing, metal-sprayed end faces of the wound capacitors, and in that the soldering discs are connected at least in their edge regions to one another and to the filter housing by means of automatic soldering.

3. Bushing filter or capacitor according to Claim 1 or 2, characterized in that the soldering discs (40, 41) rest with their outer end edges against the inner wall of the housing.

4. Bushing filter or capacitor according to Claim 3, characterized in that the soldering discs (40, 41) are inclined in the regions of their outer end edges against the inner wall of the housing.

5. Bushing filter according to Claim 1, characterized in that the tubular ferrite cores (21, 22) are separated from one another by spacers (36).

6. Bushing filter according to Claim 1, characterized in that the tubular ferrite cores (21, 22) are replaced by a single tubular ferrite core.

## Revendications

1. Filtre de traversée comportant un conducteur de traversée traversant coaxialement un boîtier de filtre et formé d'un boulon fileté, et comportant une inductance montée en série à l'intérieur du boîtier et des capacités, qui sont branchées en parallèle l'une à l'autre, dont une armature est connectée au conducteur de traversée et dont l'autre armature est connectée au boîtier de filtre,
caractérisé en ce que
des noyaux (21, 22) tubulaires ferritiques sont disposés coaxialement au conducteur (20) de traversée et l'un à côté de l'autre, chaque noyau (21, 22) tubulaire ferritique est entouré coaxialement par un condensateur (23, 24) bobiné, des anneaux (40, 41) de brasage sont brasés sur les surfaces frontales, projetées à la flamme et tournées l'une vers l'autre, des condensateurs (23, 24) bobinés et les anneaux (40, 41) de brasage sont reliés au moins par leurs zones de bord l'un à l'autre et au boîtier (25) de filtre par brasage automatique.

2. Condensateur de traversée comportant un conducteur de traversée traversant un boîtier de condensateur en forme de pot et formé d'un boulon fileté et comportant des capacités, qui sont disposées à l'intérieur du boîtier de condensateur, qui sont branchées en parallèle l'une à l'autre, dont une armature est connectée au conducteur de traversée et dont l'autre armature est connectée au boîtier de condensateur,
caractérisé en ce que
des condensateurs bobinés sont disposés coaxialement au conducteur de traversée et l'un à côté de l'autre, des anneaux de brasage sont brasés sur les surfaces frontales, projetées à la flamme et tournées l'une vers l'autre, des condensateurs bobinés et les anneaux de brasage sont reliés au moins par leurs zones de bord l'un à l'autre et au boîtier de condensateur par brasage automatique.

3. Filtre de traversée ou condensateur de traversée suivant la revendication 1 ou 2,
caractérisé en ce que
les anneaux (40, 41) de brasage sont en appui par leurs bords frontaux extérieurs contre la paroi intérieure de boîtier.

4. Filtre de traversée ou condensateur de traversée suivant la revendication 3,
caractérisée en ce que
les anneaux (40, 41) de brasage sont inclinés dans les zones de leurs bords frontaux extérieurs sur la paroi intérieure de boîtier.

5. Filtre de traversée suivant la revendication 1,
caractérisé en ce que
les noyaux (21, 22) tubulaires ferritiques sont séparés l'un de l'autre par une entretoise (36).

6. Filtre de traversée suivant la revendication 1,
caractérisé en ce que
les noyaux (21, 22) tubulaires ferritiques sont remplacés par un seul noyau tubulaire ferritique.
